(19) Europäisches Patentamt / European Patent Office / Office européen des brevets

(11) **EP 4 734 668 A1**

(12) **EUROPEAN PATENT APPLICATION**
published in accordance with Art. 153(4) EPC

(43) Date of publication:
**29.04.2026 Bulletin 2026/18**

(21) Application number: **24895848.0**

(22) Date of filing: **03.09.2024**

(51) International Patent Classification (IPC):
*H05K 1/02* (2006.01)

(52) Cooperative Patent Classification (CPC):
**H01P 3/00; H05K 1/02; H05K 1/11**

(86) International application number:
**PCT/CN2024/116551**

(87) International publication number:
**WO 2025/112749 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.11.2023 CN 202311636526**

(71) Applicant: **Huawei Technologies Co., Ltd.**
**Shenzhen, Guangdong 518129 (CN)**

(72) Inventors:
- **WANG, Qiyuan**
  **Shenzhen, Guangdong 518129 (CN)**
- **ZHAO, Gan**
  **Shenzhen, Guangdong 518129 (CN)**
- **SHENG, Wenju**
  **Shenzhen, Guangdong 518129 (CN)**
- **LI, Quanli**
  **Shenzhen, Guangdong 518129 (CN)**

(74) Representative: **Isarpatent**
**Patent- und Rechtsanwälte Part G mbB**
**Friedrichstrasse 31**
**80801 München (DE)**

(54) **CIRCUIT BOARD AND ELECTRONIC DEVICE**

(57)    A circuit board is disclosed, and relates to the field of signal transmission technologies, to resolve a problem of signal crosstalk between different channels in the circuit board. A signal layer (41) of the circuit board may include a first dielectric layer (411), two adjacent signal channels, a first ground part (4311), and a second ground part (4312). The signal channel may include a transmission line (421) disposed on the first dielectric layer (411), and the transmission line (421), the first ground part (4311), and the second ground part (4312) are located on a surface of a same side of the first dielectric layer (411), to form a coplanar waveguide (4001). The first ground part (4311) and the second ground part (4312) are located between the two adjacent signal channels and are spaced apart. The first ground part (4311) and the second ground part (4312) are configured to provide different return paths for return signals flowing through the two adjacent signal channels, to reduce crosstalk between different return signals. An electronic device (01) including the circuit board is further provided.

Direction C

FIG. 14A

## Description

This application claims priority to Chinese Patent Application No. 202311636526.4, filed with the China National Intellectual Property Administration on November 29, 2023 and entitled "CIRCUIT BOARD AND ELECTRONIC DEVICE", which is incorporated herein by reference in its entirety.

## TECHNICAL FIELD

This application relates to the field of signal transmission technologies, and in particular, to a circuit board and an electronic device.

## BACKGROUND

With continuous development of communication technologies, requirements for signal transmission are increasingly high. Currently, circuit boards are widely used to electrically connect electronic components. A signal transmission line is disposed in the circuit board, and the signal transmission line may transmit a signal between a plurality of electronic components electrically connected to the circuit board. The signal transmission line may be a microstrip line, a coplanar waveguide (coplanar waveguide, CPW), a strip line, or the like. To improve signal transmission efficiency, a plurality of signal transmission lines may be disposed in the circuit board to implement multi-channel signal transmission. However, this may cause signal crosstalk between different channels, affecting signal transmission quality.

## SUMMARY

This application provides a circuit board and an electronic device, to resolve a problem of signal crosstalk between different channels in the circuit board.

To achieve the foregoing objectives, the following technical solutions are used in this application.

An aspect of this application provides a circuit board. The circuit board may include a signal layer. The signal layer may include a first dielectric layer, two adjacent signal channels, a first ground part, and a second ground part. The signal channel may include a transmission line, and the transmission line is disposed on the first dielectric layer. The first ground part is disposed on the first dielectric layer, and the first ground part and the transmission line are located on a surface of a same side of the first dielectric layer. The second ground part is disposed on the first dielectric layer, and the second ground part and the transmission line are located on the surface of the same side of the first dielectric layer. In addition, the first ground part and the second ground part are located between the two adjacent signal channels, and the first ground part and the second ground part are spaced apart.

In conclusion, the signal layer of the circuit board provided in this embodiment of this application, for example, a flexible circuit board, includes a plurality of signal channels formed on a same side of the first dielectric layer, and the first ground part and the second ground part that are located between two adjacent signal channels, so that the first ground part and the second ground part can form a coplanar waveguide line with the transmission line in the signal channel. The first ground part and the second ground part in the coplanar waveguide line are configured to provide different return paths for return signals flowing through the two adjacent signal channels. Based on this, the two adjacent signal channels may be a first signal channel and a second signal channel, and the return signal of the first signal channel and the return signal of the second signal channel may flow back to reference ground through the first ground part and the second ground part respectively. Because the first ground part and the second ground part are spaced apart, the return signal on the first ground part and the return signal on the second ground part can be spaced from each other, so that return paths of return signals from different signal channels are decoupled from each other, to reduce crosstalk between the two return signals, thereby reducing coupling noise and improving signal transmission quality.

In an optional implementation, the circuit board further includes a reference layer, the reference layer is stacked with the signal layer, and the reference layer includes a second dielectric layer and a metal spacer layer. The metal spacer layer is disposed on the second dielectric layer. The metal spacer layer is provided with a second opening that penetrates the metal spacer layer, and the transmission line, the first ground part, and the second ground part are exposed from the second opening. The metal spacer layer may include a transmission line used to transmit a low-speed signal and block-shaped adjacent-layer reference ground. In addition, the second opening is disposed on the metal spacer layer. The first ground part and the second ground part in the coplanar waveguide may be equivalent to a signal line used to transmit a return signal. Therefore, to maintain impedance stability of the coplanar waveguide (including the transmission line, the first ground part, and the second ground part), impact of a metal layer in the reference layer on impedance of the transmission line needs to be considered, and impact of the metal layer in the reference layer on impedance of the first ground part and the second ground part further needs to be considered. Therefore, the transmission line, the first ground part, and the second ground part all need to be exposed from the second opening disposed on the metal spacer layer in the reference layer. In this way, a signal transmitted by the coplanar waveguide may mainly use the first ground part and the second ground part in the coplanar waveguide as reference ground, so that a return signal of the coplanar waveguide mainly flows back through the first ground part and the second ground part. This reduces a phenomenon that characteristic impedance of the coplanar waveguide is reduced because the adjacent-layer reference ground (located in the metal spacer layer) is used as reference ground for signal transmission of the coplanar waveguide. In addition, when no metal layer covers an upper part and a lower part of the coplanar waveguide, the metal limiting member and the coplanar waveguide may be isolated from each other through the insulated dielectric layer, for example, a third dielectric layer, a fourth dielectric layer, and the second dielectric layer. In this way, in the process of bending the electronic device, when the flexible circuit board abuts against the metal limiting member, the impact of the metal limiting member on the impedance stability of the coplanar waveguide in the flexible circuit board can be reduced.

In an optional implementation, a first end of the first ground part and a first end of the second ground part are located on a same side and are electrically connected to each other, and a second end of the first ground part and a second end of the second ground part are located on a same side and are electrically connected to each other. In this way, the adjacent first ground part and second ground part can be electrically connected to each other, so that the return signals on the first ground part and the second ground part can be combined and then transmitted to a ground layer.

In an optional implementation, the signal layer further includes a first lead and a second lead. The first lead is disposed on the first dielectric layer, the first lead is electrically connected to the transmission line, and the metal spacer layer covers the first lead. For example, one end of the first lead may be electrically connected to the transmission line, and the other end of the first lead may be electrically connected to a signal source for providing a high-speed signal, so that the high-speed signal can be transmitted to the transmission line in the coplanar waveguide through the first lead. The second lead is disposed on the first dielectric layer. The first ground part and the second ground part that are electrically connected to each other may be electrically connected to the same second lead, and the metal spacer layer covers the second lead, so that a first return signal of the first signal channel and a second return signal of the second signal channel can pass through the first ground part and the second ground part respectively, and then flow back to the reference ground through the second lead. This can simplify a structure of the circuit board.

In an optional implementation, a line width of the transmission line is greater than a line width of the first lead. In this way, coplanar coupling between the transmission line and the first ground part and the second ground part can be improved, and an insertion loss can be reduced. For example, the line width of the transmission line may be 50 μm, 100 μm, 150 μm, 200 μm, 240 μm, or 250 μm.

In an optional implementation, a line width of at least one of the first ground part and the second ground part is greater than a line width of the second lead, so that resistance on a return signal path can be reduced.

In an optional implementation, the first dielectric layer and the second dielectric layer are flexible dielectric layers. In this case, the circuit board may be a flexible circuit board.

In an optional implementation, the signal layer further includes a third dielectric layer stacked with the first dielectric layer, and the transmission line, the first ground part, and the second ground part are located between the first dielectric layer and the third dielectric layer. The reference layer further includes a fourth dielectric layer stacked with the second dielectric layer, and the metal spacer layer is located between the second dielectric layer and the fourth dielectric layer. The third dielectric layer and the fourth dielectric layer are flexible dielectric layers. The first dielectric layer and the third dielectric layer can prevent the transmission line, the first ground part, and the second ground part from being short-circuited with a metal part in the reference layer. Similarly, the second dielectric layer and the fourth dielectric layer can prevent the metal spacer layer from being short-circuited with a metal part in another reference layer or the signal layer.

In an optional implementation, there is an air gap between the signal layer and the reference layer. In this way, a distance between the metal limiting member and the coplanar waveguide can be increased through the air gap, so that the impact of the metal limiting member on the impedance stability of the coplanar waveguide in the flexible circuit board can be reduced. In addition, in the process of bending the flexible circuit board, the air gap may further provide specific deformation space, to reduce a probability that the deformed signal layer is in contact with the reference layer in a bending region, so that the flexible circuit board is more easily bent in the bending region, to improve deflection of the flexible circuit board.

In an optional implementation, the circuit board further includes an insulation support part, and the insulation support part is located in the air gap and connected to the signal layer and the reference layer, so that the insulation support part supports the signal layer and the reference layer adjacent to the signal layer, to form the air gap.

In an optional implementation, the circuit board includes at least two stacked reference layers: a first reference layer and a second reference layer. The signal layer is located between the first reference layer and the second reference layer. The metal spacer layer in any reference layer may include a signal line used to transmit a low-speed signal and adjacent-layer reference ground used for grounding, thereby improving diversity of signals transmitted by the circuit board.

In an optional implementation, the signal channel includes two transmission lines, and the signal channel may transmit a differential signal.

In an optional implementation, the reference layer includes the second dielectric layer and the metal spacer layer. The metal spacer layer is disposed on the second dielectric layer. The second opening that penetrates the metal spacer layer is disposed on the metal spacer layer, and the transmission line, the first ground part, and the second ground part are exposed from the second opening. The metal spacer layer in the first reference layer may be located between the third dielectric layer and the second dielectric layer, so that the metal spacer layer in the first reference layer and the coplanar waveguide share the third dielectric layer. In addition, the metal spacer layer in the second reference layer may be located between the first dielectric layer and the second dielectric layer, so that the metal spacer layer in the second reference layer and the coplanar waveguide share the first dielectric layer. In this way, a quantity of dielectric layers in the circuit board can be reduced, and a thickness of the electronic device can be reduced.

Another aspect of this application provides an electronic device. The electronic device may include a hinge mechanism, any one of the foregoing circuit boards, a first circuit board, and a second circuit board. The circuit board may be a flexible circuit board. A part of the flexible circuit board passes through the hinge mechanism. In addition, one end of the flexible circuit board is electrically connected to the first circuit board, the first circuit board and the second circuit board are disposed on two sides of the hinge mechanism respectively, and the other end of the flexible circuit board is electrically connected to the second circuit board. The part of the flexible circuit board passes through the hinge mechanism, and the flexible circuit board may be referred to as a through-hinge flexible circuit board. The electronic device has same technical effect as that in the foregoing embodiment. Details are not described herein again.

In an optional implementation, the electronic device further includes a metal limiting member. At least a part of the metal limiting member is stacked with the flexible circuit board. The electronic device is in a flattened state, and there is a gap between the metal limiting member and the flexible circuit board. The electronic device is in a folded state, and the metal limiting member abuts against the flexible circuit board. When the metal limiting member abuts against the flexible circuit board, there is a first distance L1 between the transmission line and a surface of a side that is of the metal limiting member and that faces the flexible circuit board, and $L1 \geq 100$ μm. In this way, in a process of bending the electronic device, when the flexible circuit board abuts against the metal limiting member, the distance between the metal limiting member and a coplanar waveguide may be long enough, so that impact of the metal limiting member on impedance stability of the coplanar waveguide in the flexible circuit board can be reduced.

In an optional implementation, the electronic device includes an insulation layer, and the insulation layer is disposed on the side that is of the metal limiting member and that faces the flexible circuit board. In this way, the insulation layer is disposed, so that the first distance L1 between the metal limiting member and the coplanar waveguide meets $L1 \geq 100$ μm, and the impact of the metal limiting member on the impedance stability of the coplanar waveguide in the flexible circuit board is reduced to about 1%.

In an optional implementation, the electronic device includes a middle frame and a rear housing. The middle frame is connected to the hinge mechanism. An accommodation cavity is formed between the rear housing and the middle frame. The first circuit board or the second circuit board is located in the accommodation cavity, and a part of the flexible circuit board is located in the accommodation cavity and is electrically connected to the first circuit board or the second circuit board. At least one of the middle frame or the rear housing is the metal limiting member. When the electronic device is in the folded state, a part that is of the flexible circuit board and that is located in a bending region may be deformed (for example, bent). The bent part of the flexible circuit board may abut against the rear housing, so that the rear housing can limit further deformation of the flexible circuit board. Alternatively, in some other embodiments, the bent part of the flexible circuit board may further abut against the middle frame, so that the middle frame can limit further deformation of the flexible circuit board.

In an optional implementation, the electronic device further includes a display, and the hinge mechanism includes a hinge body and a door plate. The hinge body is disposed on a back surface of the display. The door plate is disposed on the back surface of the display, and the door plate is connected to the hinge body and a middle frame. The flexible circuit board is located on a side that is of the door plate and that is away from the display, and the door plate is used as the metal limiting member. When the electronic device is in the folded state, the bent part of the flexible circuit board may abut against the door plate, so that the door plate can limit further deformation of the flexible circuit board.

In an optional implementation, the first ground part and the second ground part form a coplanar waveguide with a transmission line; wherein the first ground part, the second ground part and the first ground part and transmission line are in a same signal channel. For a transition of the electronic device from the flattened state to the folded state, an impedance change rate ΔZ of the coplanar waveguide falls within the range: $-10\% \leq \Delta Z \leq +10\%$. In this way, when the flexible circuit board abuts against the metal limiting member, the impact of the metal limiting member on the impedance stability of the coplanar waveguide in the flexible circuit board can be reduced.

In an optional implementation, the flexible circuit board includes a reference layer and an insulation support part. The reference layer is stacked with the signal layer, there is an air gap between the reference layer and the signal layer, and the air gap is located in a bending region. The insulation support part is located in the air gap, the insulation support layer is connected to the signal layer and the reference layer, and the insulation support layer is located in a fastening region. The insulation support part may be located in the air gap and connected to the signal layer and the reference layer, so that the insulation support part supports the signal layer and the reference layer adjacent to the signal layer, to form the air gap. It may be learned from the foregoing description that the flexible circuit board needs to be bent in the bending region, and the fastening region of the flexible circuit board does not need to be bent. Therefore, the insulation support part can be disposed in the fastening region.

## BRIEF DESCRIPTION OF DRAWINGS

FIG. 1 is a diagram of a structure of an electronic device according to an embodiment of this application;

FIG. 2 is an exploded diagram of a structure of the electronic device shown in FIG. 1;

FIG. 3 is a diagram of the electronic device in FIG. 1 in a folded state;

FIG. 4 is a sectional view obtained through sectioning along a dashed line A1-A2 in FIG. 3;

FIG. 5 is a diagram of another structure of an electronic device according to an embodiment of this application;

FIG. 6 is an enlarged view of a position B in FIG. 4;

FIG. 7 is a diagram of another structure of an electronic device according to an embodiment of this application;

FIG. 8A is a top view obtained in a direction C in FIG. 7;

FIG. 8B is a top view obtained in a direction C in FIG. 7;

FIG. 9 is a sectional view obtained through sectioning along a dashed line D1-D2 in FIG. 8A;

FIG. 10 is another top view obtained in a direction C in FIG. 7;

FIG. 11 is another top view obtained in a direction C in FIG. 7;

FIG. 12 is a diagram of a structure of a circuit board according to a related technology;

FIG. 13A is another top view obtained in a direction C in FIG. 7;

FIG. 13B is another top view obtained in a direction C in FIG. 7;

FIG. 14A is another top view obtained in a direction C in FIG. 7;

FIG. 14B is another top view obtained in a direction C in FIG. 7;

FIG. 15 is a diagram of another structure of an electronic device according to an embodiment of this application;

FIG. 16 is a diagram of a structure of a signal layer according to an embodiment of this application;

FIG. 17 is a diagram of a structure of a flexible circuit board according to an embodiment of this application;

FIG. 18 is a top view obtained in a direction E in FIG. 17;

FIG. 19 is another top view obtained in a direction E in FIG. 17;

FIG. 20 is a sectional view obtained through sectioning along a dashed line F1-F2 in FIG. 17;

FIG. 21 is a curve diagram showing that impedance of a coplanar waveguide changes with a distance between a flexible circuit board and the coplanar waveguide according to an embodiment of this application;

FIG. 22 is a diagram of another structure of an electronic device according to an embodiment of this application;

FIG. 23 is a diagram of another structure of an electronic device according to an embodiment of this application;

FIG. 24 is a diagram of another structure of a flexible circuit board according to an embodiment of this application; and

FIG. 25 is a diagram of a structure of a circuit board according to an embodiment of this application.

Reference numerals:
01: electronic device; 10: display; 20: hinge mechanism; 30a: first middle frame; 30b: second middle frame; 31a: first rear housing; 31b: second rear housing; 201a: first door plate; 201b: second door plate; 202: hinge body;

300a: first accommodation cavity; 300b: second accommodation cavity; 40: flexible circuit board; 51: first circuit board; 52: second circuit board; 401: bending region; 402: fastening region; 301: metal limiting member; 41: signal layer; 411: first dielectric layer; 421: transmission line; 420a: first signal channel; 420b: second signal channel; 430: ground cable; 4301: first opening; 4311: first ground part; 4312: second ground part; 441: first lead; 442: second lead; 443: via; 400: adjacent-layer reference ground; 413: third dielectric layer; 61: first reference layer; 62: second reference layer; 410: metal spacer layer; 4101: second opening; 412: second dielectric layer; 414: fourth dielectric layer; 70: insulation layer; 71: air gap; 72: insulation support part; and 4001: coplanar waveguide.

## DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms such as "first" and "second" below are merely for ease of description, and shall not be understood as indicating or implying relative importance or implicitly indicating a quantity of indicated technical features. Therefore, a characteristic limited by "first", "second", or the like may explicitly or implicitly include one or more characteristics. In descriptions of this application, unless otherwise stated, "a plurality of" means two or more than two.

In this application, unless otherwise clearly specified and limited, a term "connection" should be understood in a broad sense. For example, the "connection" may be a fixed mechanical connection, or may be a detachable mechanical connection or an integrated connection, or the "connection" may be a direct connection, or may be an indirect connection implemented through an intermediate medium. In addition, a "transmission connection" is a connection relationship that can implement mechanical transmission, for example, rotation and movement. The "transmission connection" includes but is not limited to a fixed mechanical connection, a detachable connection (for example, clamping and thread connection), and abutting and meshing in surface contact.

In addition, unless otherwise expressly specified and limited, the term "electrical connection" should be understood in a broad sense. For example, the "electrical connection" may be a direct electrical connection, for example, physical contact and electrical conduction between two components; or may be understood as that in a circuit structure, different components are electrically connected through a physical line that can transmit an electrical signal, such as a printed circuit board (printed circuit board, PCB) copper foil or a conducting wire, to transmit the electrical signal. Alternatively, the "electrical connection" may be an indirect electrical connection between two components through an intermediate medium. Alternatively, the "electrical connection" may be that two components are electrically connected in a spaced/non-contact manner. For example, two components are electrically connected in a capacitive coupling manner, to transmit an electrical signal.

A "communication connection" may be electrical signal transmission, and includes a wireless communication connection and a wired communication connection. The wireless communication connection does not require a physical medium and does not belong to a connection relationship that defines construction of a product.

In embodiments of this application, "perpendicular" and "parallel" are described to respectively represent being roughly vertical and being roughly parallel within an allowed error range. The error range may be a range in which a deviation angle is less than or equal to 5°, 8°, or 10° relative to being absolutely vertical and being absolutely parallel. This is not specifically limited herein.

In embodiments of this application, orientation terms such as "upper", "lower", "left", and "right" may include but are not limited to being defined relative to orientations in which components in the accompanying drawings are schematically placed. It should be understood that these directional terms may be relative concepts, are used for relative description and clarification, and may change accordingly based on a change of an orientation in which a component in an accompanying drawing is placed in the accompanying drawing.

In the accompanying drawings of embodiments of this application, components are represented by leader lines with arrowheads, parts are represented by only leader lines, and openings, apertures, or similar voids are represented by leader lines terminating in a wavy line.

An embodiment of this application provides an electronic device. The electronic device may be used in various communication systems or communication protocols, for example, a Bluetooth (Bluetooth, BT) communication technology, a global positioning system (global positioning system, GPS) communication technology, a global system of mobile communication (global system of mobile communication, GSM) communication technology, a wireless fidelity (wireless fidelity, Wi-Fi) communication technology, a wideband code division multiple access (wideband code division multiple access wireless, WCDMA) communication technology, long term evolution (long term evolution, LTE), a 5G communication technology, and another future communication technology. The electronic device in this embodiment of this application may be a mobile phone (mobile phone), a tablet computer (pad), a laptop, a smart home, a smart wearable device (for example, a smartwatch, a smart band, smart glasses, or a smart helmet), a virtual reality (virtual reality, VR) electronic device, an augmented reality (augmented reality, AR) electronic device, or the like. Alternatively, the electronic device may be a handheld device that has a wireless communication function, a computing device, another processing device connected to a wireless modem, a vehicle-mounted device, an electronic device in a 5G network, an electronic device in a future evolved public land mobile network (public land mobile network, PLMN), or the like. This is not limited in embodiments of this application.

In some embodiments, the electronic device may have a display function. In this case, the electronic device may include a display and a processor electrically connected to the display. The processor may provide display data for the display, to drive the display to display an image. For example, the processor may include one or more processing units. For example, the processor may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

In addition, the electronic device 01 may further include an external memory interface, an internal memory, a universal serial bus (universal serial bus, USB) interface, a charging management module, a power management module, a battery, an antenna, a mobile communication module, a wireless communication module, an audio module, a speaker, a receiver, a microphone, a headset jack, a sensor module, a button, a camera, and the like that are electrically connected to the processor. The sensor module may include a pressure sensor, a gyro sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

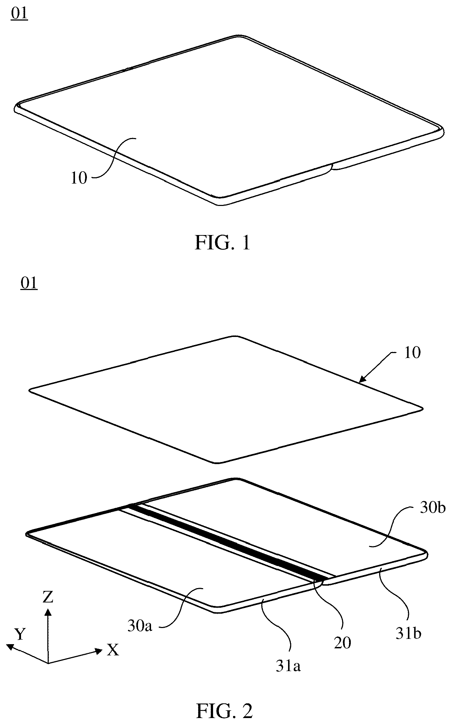

For example, for ease of description, the following uses an example in which the electronic device 01 is a foldable mobile phone for description. In this case, the electronic device 01 may include the display 10 shown in FIG. 1. The display 10 may be a flexible display. In some embodiments of this application, the display 10 may be a self-luminous display, for example, an organic light-emitting diode (organic light-emitting diode, OLED) display, a micro (micro or mini) light-emitting diode (light-emitting diode) display, or a quantum dot light-emitting diode (quantum dot light-emitting diode, QLED) display. Alternatively, in some other embodiments of this application, the display 10 may be a liquid crystal display (liquid crystal display, LCD) requiring a backlight source.

In addition, in a process of folding or flattening the electronic device 01, to support the display 10, the electronic device 01 may further include a hinge mechanism 20, two middle frames (for example, the two middle frames may be a first middle frame 30a and a second middle frame 30b respectively), and two rear housings (for example, the two rear housings may be a first rear housing 31a and a second rear housing 31b respectively) that are disposed on a back surface (a surface disposed opposite to a display surface of the display 10) of the display 10 and that are shown in FIG. 2. The first rear housing 31a is disposed on a side that is of the first middle frame 30a and that is away from the display 10, and the first rear housing 31a is connected to the first middle frame 30a. Similarly, the second rear housing 31b is disposed on a side that is of the second middle frame 30b and that is away from the display 10, and the second rear housing 31b is connected to the second middle frame 30b. The first rear housing 31a and the second rear housing 31b are disposed on two sides of the hinge mechanism 20 respectively, and either the first rear housing 31a or the second rear housing 31b may be rotatably or slidably connected to the hinge mechanism 20.

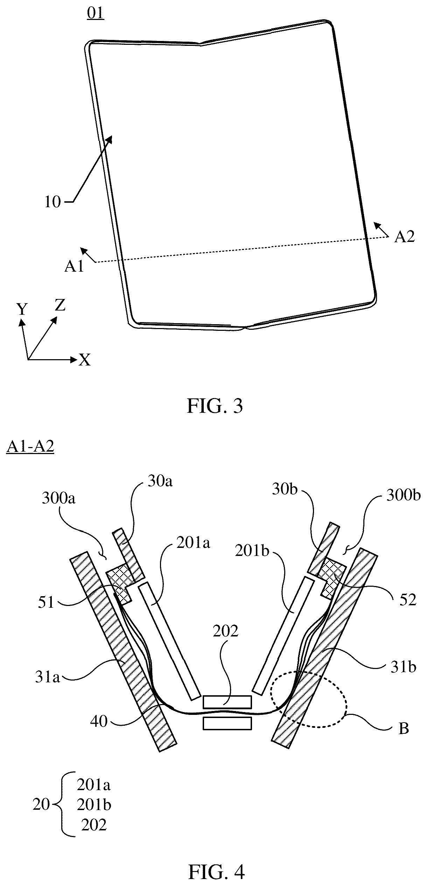

In this case, the display 10 may be connected to the hinge mechanism 20, the first middle frame 30a, and the second middle frame 30b. When an initial state of the electronic device 01 is a flattened state shown in FIG. 1, a user may hold the electronic device 01 to apply an external force to the first middle frame 30a and the second middle frame 30b shown in FIG. 2, to fold the first middle frame 30a and the second middle frame 30b, so that the first middle frame 30a and the second middle frame 30b rotate or slide relative to the hinge mechanism 20, the display 10 is bent and deformed as shown in FIG. 3, and the electronic device 01 is in a folded state shown in FIG. 3.

For example, in this embodiment of this application, the flattened state of the electronic device 01 may mean that, in the display 10, an included angle between two parts connected to the first middle frame 30a and the second middle frame 30b respectively may be equal to or approximately equal to 180°. The folded state of the electronic device 01 may mean that, in the display 10, the included angle between the two parts connected to the first middle frame 30a and the second middle frame 30b respectively may be less than 180°. To describe a position relationship between components in the electronic device 01, an XYZ coordinate system shown in FIG. 2 may be established. An XY plane is parallel to a display surface of the display 10 in the flattened state of the electronic device 01, an X direction is a direction in which the first middle frame 30a points to the second middle frame 30b, and a Y direction is parallel to a rotation center of the hinge mechanism 20. In addition, a Z direction is a direction in which the display and the middle frame (for example, the first middle frame 30a and the second middle frame 30b) are stacked.

Based on this, as shown in FIG. 4 (a sectional view obtained through sectioning along a dashed line A1-A2 in FIG. 3), an accommodation cavity, for example, a first accommodation cavity 300a, may be formed between the first middle frame 30a and the first rear housing 31a, and an accommodation cavity, for example, a second accommodation cavity 300b, may be formed between the second middle frame 30b and the second rear housing 31b. In addition, the electronic device 01 may further include a flexible circuit board (flexible printed circuit board, FPC) 40, a first circuit board 51, and a second circuit board 52. The first circuit board 51 and the second circuit board 52 may be printed circuit boards (printed circuit board, PCB). To prevent a plurality of circuit boards from occupying large layout space in a same accommodation cavity, the first circuit board 51 and the second circuit board 52 may be disposed on the two sides of the hinge mechanism 20 respectively, so that the first circuit board 51 is located in the first accommodation cavity 300a, and the second circuit board 52 is located in the second accommodation cavity 300b.

For example, functions of the first circuit board 51 and the second circuit board 52 may be the same or may be different. This is not limited in this application. For example, at least one of the first circuit board 51 and the second circuit board 52 may be a mainboard (mainboard), an interface circuit board (for example, a type-C interface circuit board or a type-A interface circuit board), or a circuit board configured to transmit a control signal.

Based on this, still as shown in FIG. 4, to enable the flexible circuit board 40 to electrically connect the first circuit board 51 and the second circuit board 52 located in different accommodation cavities, a part of the flexible circuit board 40 passes through the hinge mechanism 20. The flexible circuit board 40 may be referred to as a through-hinge FPC. One end of the flexible circuit board 40 extends into the first accommodation cavity 300a, and is electrically connected to the first circuit board 51. The other end of the flexible circuit board 40 extends into the second accommodation cavity 300b, and is electrically connected to the second circuit board 52. For example, the two ends of the flexible circuit board 40 may be welded to the first circuit board 51 and the second circuit board 52 respectively, so that the flexible circuit board 40 can be electrically connected to the first circuit board 51 and the second circuit board 52.

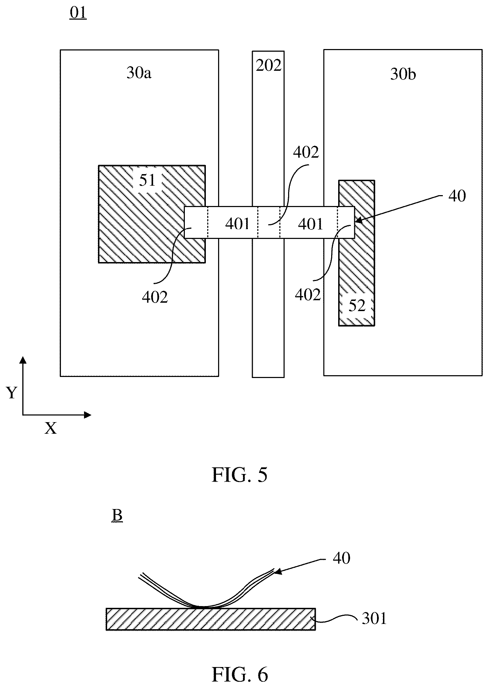

In some embodiments of this application, as shown in FIG. 5, the first circuit board 51 may be disposed on the first middle frame 30a, and the first circuit board 51 may be a mainboard of the electronic device 01. The second circuit board 52 may be disposed on the second middle frame 30b, and the second circuit board 52 may be an interface circuit board. The first circuit board 51 and the second circuit board 52 that are located in different display parts may be electrically connected to each other through through-hinge arrangement of the flexible circuit board 40, to implement signal transmission between the mainboard and the interface circuit board through the flexible circuit board 40.

It can be learned from the foregoing description that, still as shown in FIG. 5, the two ends of the flexible circuit board 40 are connected to the first circuit board 51 and the second circuit board 52 respectively. In addition, a part that is of the flexible circuit board 40 and that passes through the hinge mechanism 20 may also be connected to the hinge mechanism 20. For example, the flexible circuit board 40 is connected to the hinge mechanism 20 in a bonding manner. Therefore, parts that are of the flexible circuit board 40 and that are connected to the first circuit board 51, the second circuit board 52, and the hinge mechanism 20 respectively are not deformed in a process of bending the electronic device 01. A part of the flexible circuit board 40 other than the parts connected to the foregoing components (the first circuit board 51, the second circuit board 52, and the hinge mechanism 20) may be deformed in the process of bending the electronic device 01.

In this case, the flexible circuit board 40 may include a bending region 401 and a fastening region 402. The parts that are of the flexible circuit board 40 and that are connected to the first circuit board 51, the second circuit board 52, and the hinge mechanism 20 (as shown in FIG. 4) respectively are located in fastening regions 402. Therefore, the part that is of the flexible circuit board 40 and that is located in the fastening region 402 is not deformed or is not deformed approximately in the process of bending the electronic device 01. In addition, a part of the flexible circuit board 40 other than the parts in the fastening region 402 may be the foregoing bending region 401. Therefore, the part that is of the flexible circuit board 40 and that is located in the bending region 401 may be deformed in the process of bending the electronic device 01.

The foregoing describes disposing of the bending region 401 and the fastening region 402 of the flexible circuit board 40 by using an example in which the flexible circuit board 40 is separately connected to the first circuit board 51, the second circuit board 52, and the hinge mechanism 20 (as shown in FIG. 4). In some other embodiments of this application, the flexible circuit board 40 may be connected to the first circuit board 51 and the second circuit board 52, and there may be no connection relationship between the flexible circuit board 40 and the hinge mechanism 20. In this case, the part that passes through the hinge mechanism 20 in the flexible circuit board 40 may be located in the bending region 401. For ease of description, the following uses the example in which the flexible circuit board 40 is separately connected to the first circuit board 51, the second circuit board 52, and the hinge mechanism 20 (as shown in FIG. 4) for description.

Based on this, when the electronic device is in the folded state, the part that is of the flexible circuit board 40 and that is located in the bending region 401 may be deformed (for example, bent), as shown in FIG. 4. The bent part of the flexible circuit board 40 may abut against the rear housing (for example, the first rear housing 31a and the second rear housing 31b), so that the rear housing can limit further deformation of the flexible circuit board 40. Alternatively, in some other embodiments, the bent part of the flexible circuit board 40 may further abut against the middle frame (for example, the first middle frame 30a and the second middle frame 30b), so that the middle frame can limit further deformation of the flexible circuit board 40. Alternatively, the bent part of the flexible circuit board 40 may abut against both the rear housing and the middle frame. For example, the rear housing and the middle frame may be made of a metal material. Therefore, at least one of the rear housing (for example, the first rear housing 31a and the second rear housing 31b) and the middle frame (for example, the first middle frame 30a and the second middle frame 30b) may be referred to as a metal limiting member 301 shown in FIG. 6 (an enlarged view of a position B in FIG. 4).

Alternatively, still as shown in FIG. 4, the hinge mechanism 20 may include a hinge body 202 and two door plates (for example, the two door plates are a first door plate 201a and a second door plate 201b respectively). The door plate may be disposed on the back surface of the display 10 (as shown in FIG. 2). The flexible circuit board 40 may be located on a side that is of the door plate (for example, the first door plate 201a and the second door plate 201b) and that is away from the display 10 (as shown in FIG. 2). The first door plate 201a and the second door plate 201b may be disposed on two sides of the hinge body 202 respectively, and either the first door plate 201a or the second door plate 201b may be connected to the hinge body 202. In addition, the first door plate 201a may be connected to the first middle frame 30a, and the second door plate 201b may be connected to the second middle frame 30b. The door plate may be rotatably connected to, slidably connected to, or fastened to either the hinge body 202 or the middle frame, so that in the process of bending the electronic device 01, a display bending part 103 of the display 10 can be bent and deformed as shown in FIG. 3, and the electronic device 01 is in the folded state shown in FIG. 3.

Based on this, still as shown in FIG. 4, when the electronic device is in the folded state, the bent part of the flexible circuit board 40 may abut against the door plate (for example, the first door plate 201a and the second door plate 201b), so that the door plate can limit further deformation of the flexible circuit board 40. For example, the door plate may be made of a metal material. Therefore, the door plate (for example, the first door plate 201a and the second door plate 201b) may be referred to as the metal limiting member 301 shown in FIG. 6.

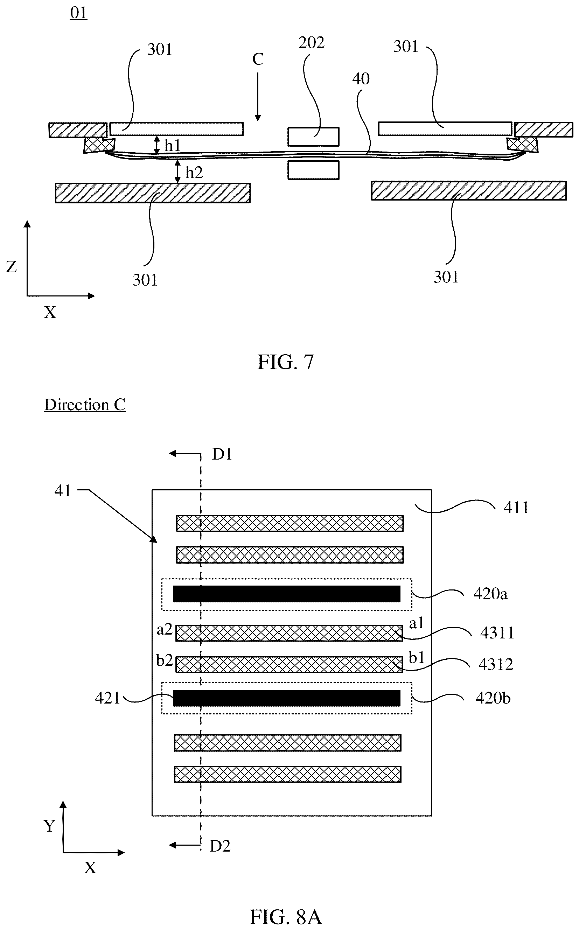

In this case, as shown in FIG. 6, at least a part of the metal limiting member 301 may be stacked with the flexible circuit board 40. In this way, when the electronic device is in the folded state, the metal limiting member 301 may abut against the flexible circuit board 40, to limit further deformation of the flexible circuit board 40 via the metal limiting member 301. In addition, when the electronic device 01 is in the flattened state shown in FIG. 7, there may be a gap, for example, a gap h1 or a gap h2, between the metal limiting member 301 and the flexible circuit board 40. The gap h1 or the gap h2 may represent a gap between the flexible circuit board 40 and different metal limiting members 301, and the gap h1 or the gap h2 provides specific space for bending and deformation of the flexible circuit board 40.

Based on this, the circuit board provided in this embodiment of this application may be the foregoing flexible circuit board 40. The following describes a structure of the flexible circuit board 40 in detail by using an example. In some embodiments of this application, the flexible circuit board 40 may include a signal layer 41 shown in FIG. 8A (a top view obtained in a direction C in FIG. 7). The signal layer 41 may include a first dielectric layer 411, two adjacent signal channels (for example, the two signal channels may be a first signal channel 420a and a second signal channel 420b respectively), a first ground part 4311, and a second ground part 4312. The first ground part 4311 and the second ground part 4312 are located between the two adjacent signal channels (for example, the first signal channel 420a and the second signal channel 420b). In addition, the first ground part 4311 and the second ground part 4312 are spaced apart. Either the first signal channel 420a or the second signal channel 420b may include a transmission line 421. A quantity of signal channels is not limited in this application. FIG. 8A shows only the two adjacent signal channels, for example, the first signal channel 420a and the second signal channel 420b. In addition, signals transmitted on different signal channels may be the same or may be different. This is not limited in this application.

In some embodiments of this application, as shown in FIG. 8A, the first ground part 4311 and the second ground part 4312 between the two adjacent signal channels (for example, the first signal channel 420a and the second signal channel 420b) may be disposed independently of each other, and the first ground part 4311 and the second ground part 4312 may be separately grounded.

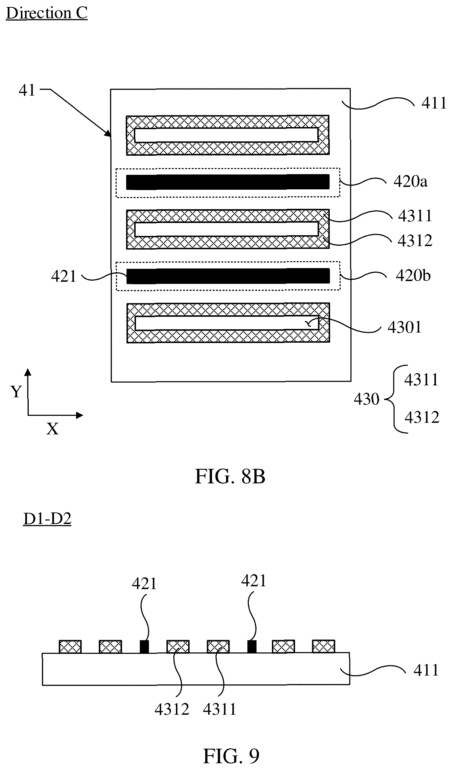

Alternatively, in some other embodiments of this application, a first end a1 of the first ground part 4311 and a first end b1 of the second ground part 4312 that are located on a same side may be electrically connected to each other, and a second end a2 of the first ground part 4311 and a second end b2 of the second ground part 4312 that are located on a same side may be located on the same side and electrically connected to each other, so that the first ground part 4311 and the second ground part 4312 that are electrically connected to each other form a ground cable 430 shown in FIG. 8B.

For example, in a process of manufacturing the ground cable 430, a metal thin film pattern layer may be formed on the first dielectric layer 411, and then, a first opening 4301 shown in FIG. 8B is formed on the metal thin film layer by using a photoetching (mask) process, so as to divide the metal thin film pattern layer into the first ground part 4311 and the second ground part 4312 through the first opening 4301. Alternatively, for another example, the first ground part 4311 and the second ground part 4312 that are independent and are spaced apart may be formed on the first dielectric layer 411.

Then, a metal layer for connecting the first ground part 4311 and the second ground part 4312 is formed at end parts of the first ground part 4311 and the second ground part 4312, to form the ground cable 430 shown in FIG. 8B. A process of manufacturing the first ground part 4311 and the second ground part 4312 is not limited in this application. For ease of description, the following uses an example in which the two adjacent first ground part 4311 and second ground part 4312 shown in FIG. 8B are electrically connected to form the ground cable 430 for description.

In addition, as shown in FIG. 9 (a sectional view obtained through sectioning along D1-D2 in FIG. 8A), the transmission line 421 and the ground cable 430 may be disposed on the first dielectric layer 411, and the transmission line 421 and the ground cable 430 may be located on a surface of a same side of the first dielectric layer 411. In this way, the transmission line 421 may form a coplanar waveguide with the ground cable 430 adjacent to the transmission line 421. The coplanar waveguide has advantages such as a high transmission speed, a long transmission distance, and a strong anti-interference capability.

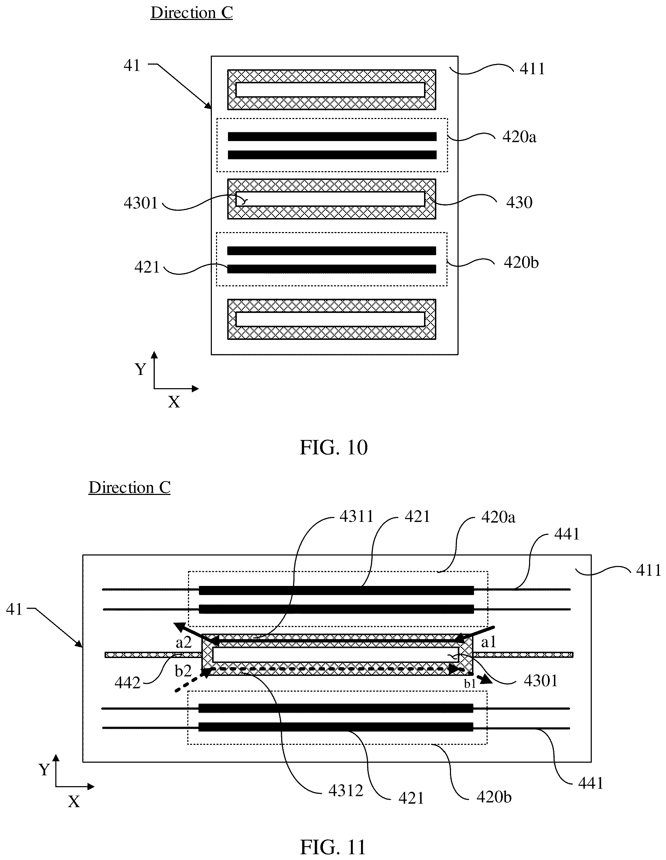

Therefore, in some embodiments of this application, the transmission line 421 may be configured to transmit a high-speed signal. For example, a transmission distance of the high-speed signal may be greater than $1/6\lambda$. $\lambda$ is a wavelength of the high-speed signal. The high-speed signal may be a high-speed digital signal or a radio frequency signal. In some embodiments of this application, the high-speed digital signal may include a differential signal. In this case, as shown in FIG. 10 (a top view obtained in the direction C in FIG. 7), a same signal channel, for example, the first signal channel 420a (or the second signal channel 420b), may include two transmission lines 421. For example, the high-speed digital signal may be stored or read data, interface data, or screen control data.

For example, the first dielectric layer 411 may be a substrate made of a polymer material. A metal layer, for example, a copper layer, is formed on the first dielectric layer 411. Then, a part of the copper layer is reserved by using a patterning process like photoetching or printing, to form the transmission line 421 and the ground cable 430, and the other part is removed.

Based on this, it can be learned from the foregoing description that, as shown in FIG. 8B or FIG. 10, the first ground part 4311 and the second ground part 4312 between the two adjacent signal channels (for example, the first signal channel 420a and the second signal channel 420b) are spaced apart. Therefore, a return signal of a high-speed signal transmitted on the first signal channel 420a may flow back to reference ground after passing through the first ground part 4311. In addition, a return signal of a high-speed signal transmitted on the second signal channel 420b may flow back to the reference ground through the second ground part 4312. The foregoing two return signals may be isolated via a gap, for example, the first opening 4301, between the first ground part 4311 and the second ground part 4312.

The following describes return paths of return signals of different signal channels on the first ground part 4311 and the second ground part 4312 by using examples. For example, as shown in FIG. 11, the first ground part 4311 is spaced between the first signal channel 420a and the first opening 4301, and the second ground part 4312 is spaced between the second signal channel 420b and the first opening 4301. In this case, a first return signal (represented by solid arrows in the figure) of a high-speed signal transmitted on the first signal channel 420a may flow back to the reference ground from right to left (that is, from the first end a1 to the second end a2) through the first ground part 4311. In addition, a second return signal (represented by dashed arrows in the figure) of a high-speed signal transmitted on the second signal channel 420b may flow back to the reference ground from left to right (that is, from the second end b2 to the first end b1) through the second ground part 4312.

In FIG. 11, an example in which a transmission direction of the return signal of the first signal channel 420a on the first ground part 4311 is opposite to a transmission direction of the return signal of the second signal channel 420b on the second ground part 4312 is used for description. In some other embodiments of this application, a transmission direction of the return signal of the first signal channel 420a on the first ground part 4311 may alternatively be the same as a transmission direction of the return signal of the second signal channel 420b on the second ground part 4312.

In conclusion, the signal layer 41 shown in FIG. 11 of the circuit board provided in this embodiment of this application, for example, the flexible circuit board 40 (as shown in FIG. 4), includes a plurality of signal channels formed on the same side of the first dielectric layer 411, and the first ground part 4311 and the second ground part 4312 that are located between two adjacent signal channels (for example, the first signal channel 420a and the second signal channel 420b). The first ground part 4311 and the second ground part 4312 may form a coplanar waveguide line with the transmission line 421 in the signal channel. The coplanar waveguide line may be configured to transmit a high-speed signal, for example, a high-speed digital signal or a radio frequency signal. For the high-speed signal, the high-speed signal needs to flow back through the first ground part 4311 or the second ground part 4312 in the coplanar waveguide.

Based on this, a first return signal (represented by solid arrows in FIG. 11) of the first signal channel 420a and a second return signal (represented by dashed arrows in FIG. 11) of the second signal channel 420b may flow back to reference ground through the first ground part 4311 and the second ground part 4312 respectively. The first ground part 4311 is used as a return path of the first return signal, and the second ground part 4312 is used as a return path of the second return signal. Because the first ground part 4311 and the second ground part 4312 are spaced apart, the first return signal on the first ground part 4311 and the second return signal on the second ground part 4312 can be spaced from each other, so that return paths of return signals from different signal channels are decoupled from each other, to reduce crosstalk between the two return signals, thereby reducing coupling noise and improving signal transmission quality.

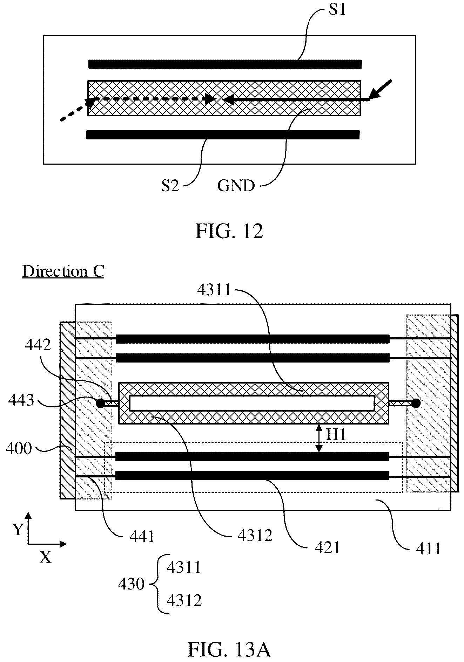

Based on this, as shown in FIG. 11, when a direction of the first return signal on the first ground part 4311 is opposite to a direction of the second return signal on the second ground part 4312, mutual cancellation between the first return signal and the second return signal may be reduced. This improves signal transmission efficiency. In contrast, for a circuit board with a coplanar waveguide provided in a related technology, as shown in FIG. 12, return signals of adjacent transmission signal lines S1 and S2 have opposite directions and flow into a same ground cable GND, and the return signals of the two transmission signal lines are not isolated from each other in the ground cable GND. As a result, mutual cancellation occurs, and coupling noise is generated.

Based on this, to transmit the high-speed signal from a signal source to the transmission line 421 shown in FIG. 11 and make the return signal of the high-speed signal flow back to the reference ground through the first ground part 4311 or the second ground part 4312, the signal layer 41 may further include a first lead 441 and a second lead 442. The first lead 441 may be disposed on the first dielectric layer 411. One end of the first lead 441 may be electrically connected to the transmission line 421, and the other end of the first lead 441 may be electrically connected to the signal source for providing the high-speed signal, so that the high-speed signal can be transmitted to the transmission line 421 in the coplanar waveguide through the first lead 441.

In addition, the second lead 442 is disposed on the first dielectric layer 411. The first ground part 4311 and the second ground part 4312 that are electrically connected to each other may be electrically connected to the same second lead 442, so that the first return signal (represented by the solid arrows in FIG. 11) of the first signal channel 420a and the second return signal (represented by the dashed arrows in FIG. 11) of the second signal channel 420b can pass through the first ground part 4311 and the second ground part 4312 respectively, and then flow back to the reference ground through the same second lead 442. This can simplify a structure of the flexible circuit board.

In some embodiments of this application, to make the return signals on the first ground part 4311 and the second ground part 4312 flow back to the reference ground through the second lead 442, as shown in FIG. 13A, the flexible circuit board 40 further includes adjacent-layer reference ground 400 stacked with the signal layer 41. The flexible circuit board 40 may further include a via (via) 443. The via 443 may penetrate the first dielectric layer 411, so that the second lead 442 is electrically connected to the adjacent-layer reference ground 400 through the via 443, and the adjacent-layer reference ground 400 is used as reference ground of the second lead 442. For example, the adjacent-layer reference ground 400 may be of a block-shaped metal layer structure (for example, a block-shaped metal copper leakage region).

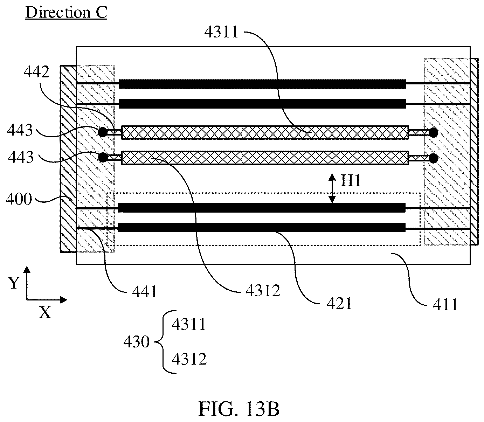

In FIG. 13A, an example in which the adjacent first ground part 4311 and second ground part 4312 are electrically connected to each other, and then are electrically connected to the adjacent-layer reference ground 400 through the same second lead 442 and the same via 443 is used for description. In some other embodiments of this application, as shown in FIG. 13B, when the first ground part 4311 and the second ground part 4312 are disposed independently of each other, the first ground part 4311 and the second ground part 4312 may be electrically connected to the adjacent-layer reference ground 400 through different vias 443.

In addition, in some embodiments of this application, as shown in FIG. 11, a line width (a size in the Y direction, that is, perpendicular to an extension direction of a signal line) of the transmission line 421 that forms the coplanar waveguide may be greater than a line width of the first lead 441. For example, the line width of the transmission line 421 may range from 50 μm to 250 μm. In this way, coplanar coupling between the transmission line 421 and the ground cable 430 can be improved, and an insertion loss can be reduced. For example, the line width of the transmission line 421 may be 50 μm, 100 μm, 150 μm, 200 μm, 240 μm, or 250 μm.

In addition, because the adjacent-layer reference ground 400 shown in FIG. 13A may be of a block-shaped metal layer structure, the adjacent-layer reference ground 400 has a low-impedance characteristic, and a line width (a size in the Y direction) of the second lead 442 that is used to electrically connect the first ground part 4311 and the second ground part 4312 to the adjacent-layer reference ground 400 may be less than a line width (a size in the Y direction) of the ground cable 430, to reduce resistance on a return signal path.

Based on this, still as shown in FIG. 13A, when the ground cable 430 is far away from the adjacent transmission line 421, coplanar coupling is not easily generated between the transmission line 421 and the ground cable 430. In addition, when the ground cable 430 is close to the adjacent transmission line 421, because the ground cable 430 is electrically conductive, the ground cable 430 pulls down impedance of the transmission line 421. As a result, the impedance of the transmission line 421 is unstable. Based on this, spacing H1 between the ground cable 430 and the adjacent transmission line 421 may range from 20 μm to 100 μm. In this way, coplanar coupling can be generated between the transmission line 421 and the ground cable 430, and the impedance of the transmission line 421 can be stabilized. For example, the spacing H1 between the ground cable 430 and the adjacent transmission line 421 may range from 20 μm to 100 μm. For example, H1 may be 20 μm, 30 μm, 40 μm, 50 μm, 60 μm, 70 μm, 80 μm, 90 μm, or 100 μm.

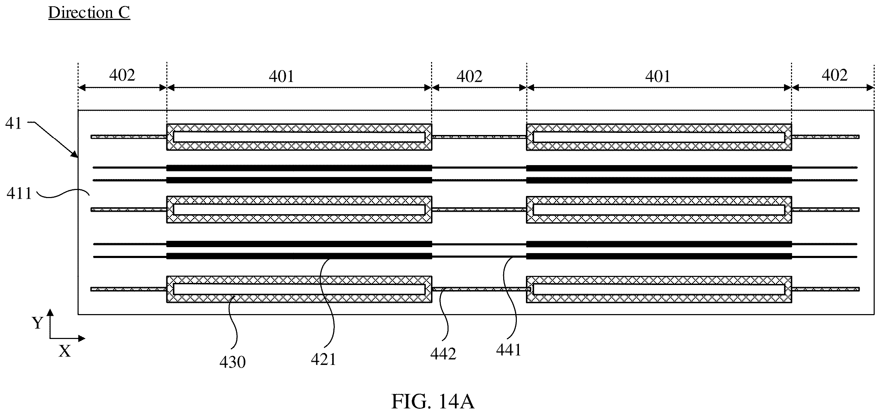

It may be learned from the foregoing description that the flexible circuit board 40 includes the bending region 401 and the fastening region 402 shown in FIG. 5. The parts that are of the flexible circuit board 40 and that are connected to the first circuit board 51, the second circuit board 52, and the hinge mechanism 20 (as shown in FIG. 4) respectively are located in the fastening regions 402. A part of the flexible circuit board 40 other than the fastening regions 402 is the bending region 401. Therefore, the bending region 401 occupies most of an area of the flexible circuit board 40. Based on this, as shown in FIG. 14A, the transmission line 421 and the ground cable 430 that are used to form the coplanar waveguide may be located in the bending region 401, so that the flexible circuit board 40 can transmit high-speed data. In addition, the first lead 441 and the second lead 442 may be disposed in the fastening region 402.

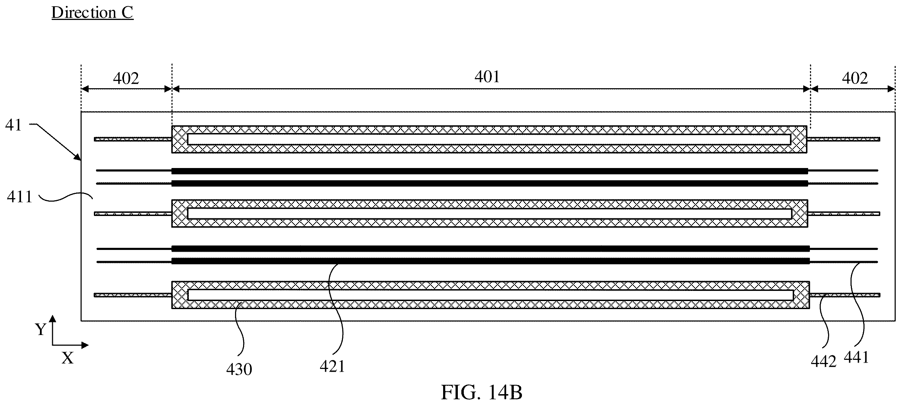

In FIG. 14A, an example in which the flexible circuit board 40 is separately connected to the first circuit board 51, the second circuit board 52, and the hinge mechanism 20 shown in FIG. 4 is used for description. In some other embodiments of this application, the flexible circuit board 40 is connected to the first circuit board 51 and the second circuit board 52, and there may be no connection relationship between the flexible circuit board 40 and the hinge mechanism 20. In this case, as shown in FIG. 14B, two ends of the flexible circuit board may be located in the fastening regions 402, so that the two ends of the flexible circuit board are connected to the first circuit board 51 and the second circuit board 52 shown in FIG. 4 respectively, and parts that are of the flexible circuit board and are located between two fastening regions 402 are bending regions 401. For ease of description, the following uses an example in which the bending region 401 and the fastening region 402 in the signal layer 41 in the flexible circuit board are disposed in the manner shown in FIG. 14A for description. It may be learned from the foregoing description that the coplanar waveguide formed by the transmission line 421 and the ground cable 430 in the signal layer 41 is configured to transmit a high-speed signal, for example, a high-speed digital signal or a radio frequency signal. In some embodiments of this application, in the signal layer 41 of the same flexible circuit board, different transmission channels, for example, the first signal channel 420a and the second signal channel 420b in FIG. 10, may transmit the high-speed digital signal and the radio frequency signal respectively.

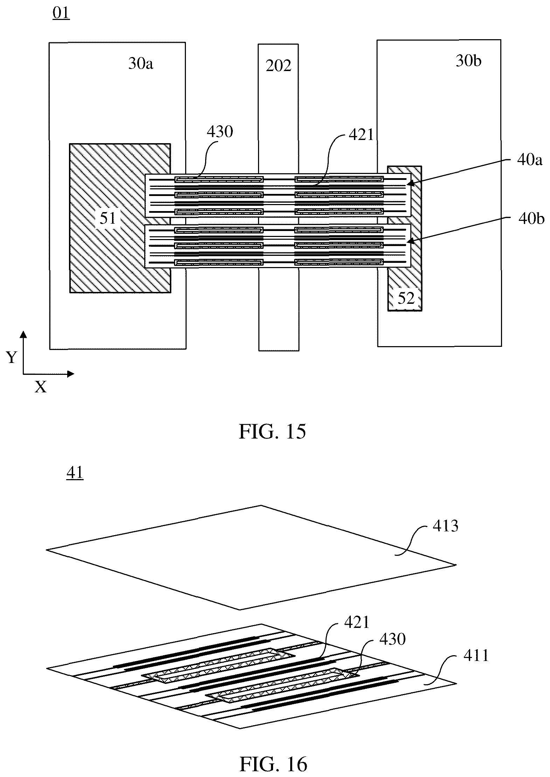

Alternatively, in some other embodiments of this application, as shown in FIG. 15, the electronic device 01 may include two flexible circuit boards: a flexible circuit board 40a and a flexible circuit board 40b. Two ends of either the flexible circuit board 40a or the flexible circuit board 40b are electrically connected to the first circuit board 51 and the second circuit board 52. A coplanar waveguide formed by the transmission line 421 and the ground cable 430 in the flexible circuit board 40a may transmit a high-speed digital signal, and a coplanar waveguide formed by the transmission line 421 and the ground cable 430 in the flexible circuit board 40b may transmit a radio frequency signal. The foregoing descriptions are provided by using a quantity of flexible circuit boards of the electronic device 01 and a transmitted signal as examples, and does not constitute a limitation on the quantity of flexible circuit boards and the transmitted signal.

The foregoing description is provided by using an example in which the signal layer 41 includes one dielectric layer, for example, the first dielectric layer 411 shown in FIG. 14A. In some other embodiments of this application, as shown in FIG. 16, the signal layer 41 may further include a third dielectric layer 413. The third dielectric layer 413 may be stacked with the first dielectric layer 411, and the transmission line 421 and the ground cable 430 are located between the first dielectric layer 411 and the third dielectric layer 413. For example, the transmission line 421 and the ground cable 430 may be manufactured on the first dielectric layer 411. Alternatively, for another example, the transmission line 421 and the ground cable 430 may be manufactured on a surface that is of the third dielectric layer 413 and that faces the first dielectric layer 411. Materials of the third dielectric layer 413 and the first dielectric layer 411 may be the same, and both the third dielectric layer 413 and the first dielectric layer 411 may be flexible dielectric layers.

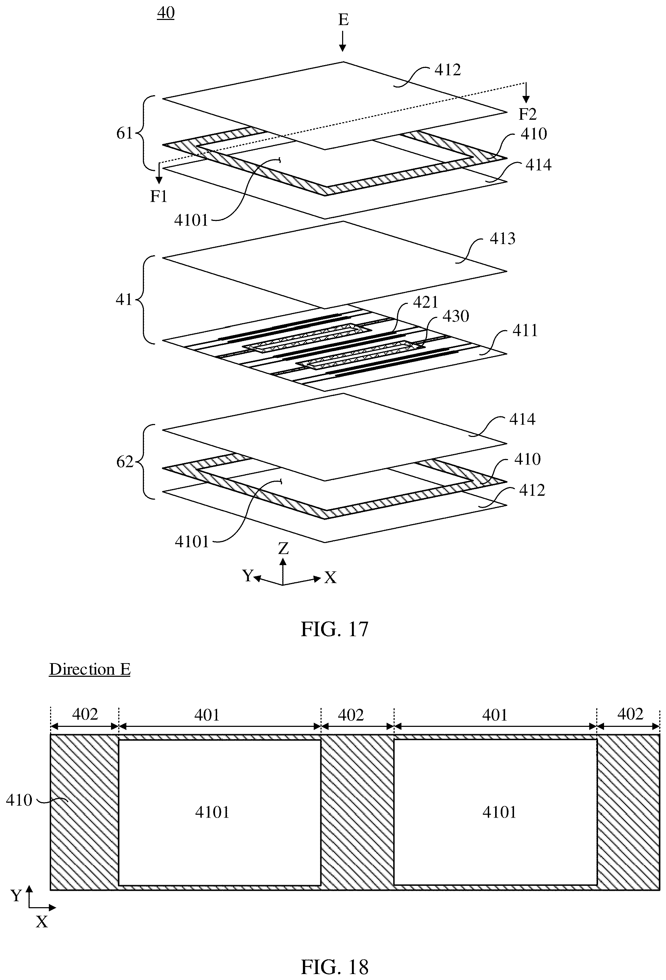

Based on this, in addition to the high-speed signal, any flexible circuit board of the electronic device 01 may further transmit a non-high-speed signal like a low-speed signal or a ground signal. Based on this, to enable the flexible circuit board to transmit the non-high-speed signal, in some embodiments of this application, the flexible circuit board may further include at least one reference layer. For example, as shown in FIG. 17, two reference layers: a first reference layer 61 and a second reference layer 62 may be disposed on the flexible circuit board 40.

The first reference layer 61 and the second reference layer 62 may be stacked with the signal layer 41, and the signal layer 41 may be located between the first reference layer 61 and the second reference layer 62. In some embodiments of this application, either the first reference layer 61 or the second reference layer 62 may include a second dielectric layer 412, a metal spacer layer 410, and a fourth dielectric layer 414, and the metal spacer layer 410 is stacked between the second dielectric layer 412 and the fourth dielectric layer 414. The second dielectric layer 412 may be located on a side that is of the fourth dielectric layer 414 and that is away from the signal layer 41. For example, the metal spacer layer 410 may be disposed on the second dielectric layer 412. Alternatively, the metal spacer layer 410 may be disposed on the fourth dielectric layer 414. This is not limited in this application.

The second dielectric layer 412 and the fourth dielectric layer 414 may be flexible dielectric layers. For example, materials of the second dielectric layer 412 and the fourth dielectric layer 414 may be the same as the material of the first dielectric layer 411. The metal spacer layer 410 may include a signal line used to transmit the non-high-speed signal and block-shaped reference ground (referred to as adjacent-layer reference ground below). In this way, the metal spacer layer 410 in either the first reference layer 61 or the second reference layer 62 may include a signal line used to transmit a low-speed signal and adjacent-layer reference ground used for grounding, thereby improving diversity of signals transmitted by the flexible circuit board 40. The first dielectric layer 411 and the third dielectric layer 413 can prevent the transmission line 421, the first ground part 4311 and the second ground part 4212 from being short-circuited with a metal part in the reference layer (for example, the first reference layer 61 and the second reference layer 62). Similarly, the second dielectric layer 412 and the fourth dielectric layer 414 can prevent the metal spacer layer 410 from being short-circuited with a metal part in another reference layer or the signal layer 41.

It may be learned from the foregoing description that, as shown in FIG. 18 (a top view obtained in a direction E in FIG. 17), a second opening 4101 that penetrates the metal spacer layer 410 may be disposed on the metal spacer layer 410, and the second opening 4101 is configured to expose the transmission line 421 and the ground cable 430 in the signal layer 41 shown in FIG. 17. Because the transmission line 421 and the ground cable 430 are disposed in the bending region 401, still as shown in FIG. 18, the second opening 4101 in the metal spacer layer 410 is located in the bending region 401, and a part that is of the metal spacer layer 410 and that is not provided with the second opening 4101 may be located in the fastening region 402.

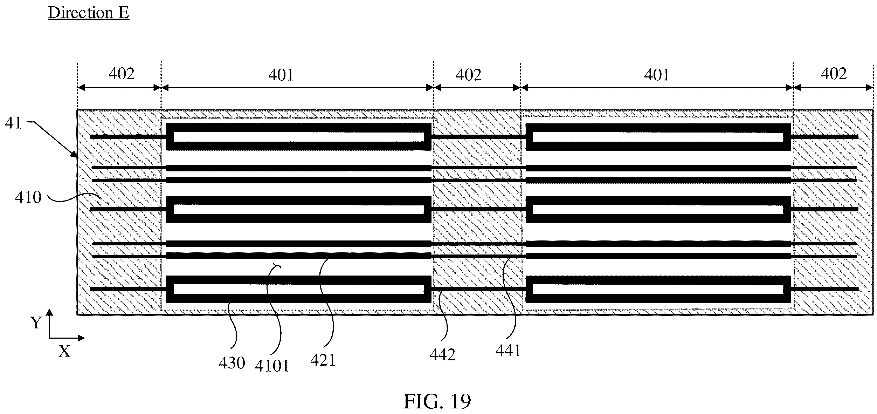

Based on this, that the transmission line 421 and the ground cable 430 are exposed from the second opening 4101 may mean that, as shown in FIG. 19 (a top view obtained in the direction E in FIG. 17), vertical projections of the transmission line 421 and the ground cable 430 on the metal spacer layer 410 may be located in the second opening 4101. In addition, the first lead 441 electrically connected to the transmission line 421 and the second lead 442 electrically connected to the ground cable 430 are located in the fastening region 402. Therefore, the metal spacer layer 410 may cover the first lead 441 and the second lead 442. In other words, vertical projections of the first lead 441 and the second lead 442 on the metal spacer layer 410 overlap the part that is of the metal spacer layer 410 and that is not provided with the second opening 4101.

It can be learned from the foregoing description that the first opening is disposed on the ground cable 430 in the coplanar waveguide 4001 (as shown in FIG. 11). Therefore, the ground cable 430 is no longer block-shaped metal reference ground, but is equivalent to a signal line used to transmit a return signal. Therefore, to maintain impedance stability of the coplanar waveguide 4001, impact of the metal layer in the reference layer (for example, the first reference layer 61 or the second reference layer 62) on impedance of the transmission line 421 needs to be considered, and impact of the metal layer in the reference layer on impedance of the ground cable 430 further needs to be considered. Therefore, both the transmission line 421 and the ground cable 430 need to be exposed from the second opening 4101 disposed on the metal spacer layer 410 in either the first reference layer 61 or the second reference layer 62.

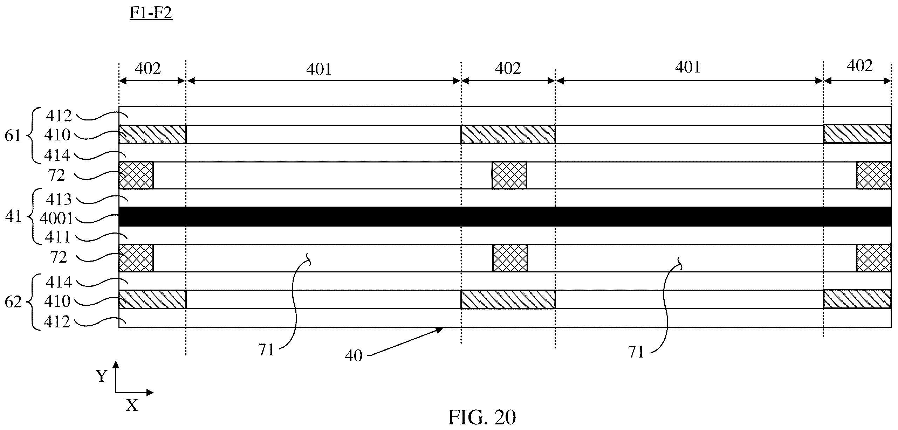

In this case, as shown in FIG. 20 (a sectional view obtained through sectioning along a dashed line F1-F2 in FIG. 17), no metal layer covers an upper part and a lower part of the coplanar waveguide 4001 (including the transmission line 421 and the ground cable 430 shown in FIG. 17). In this way, a signal transmitted by the coplanar waveguide 4001 may mainly use the ground cable 430 in the coplanar waveguide 4001 as reference ground, so that a return signal of the coplanar waveguide 4001 mainly flows back through the ground cable 430. This reduces a phenomenon that characteristic impedance of the coplanar waveguide 4001 is reduced because the adjacent-layer reference ground (located in the metal spacer layer 410) is used as reference ground for signal transmission of the coplanar waveguide 4001.

In addition, it may be seen from FIG. 4 that, in the process of bending the electronic device 01, at least one of the first door plate 201a, the second door plate 201b, the first rear housing 31a, the second rear housing 31b, the first middle frame 30a, or the second middle frame 30b may be used as the metal limiting member 301, to abut against the flexible circuit board 40. In this case, because the metal limiting member 301 is a conductor, when the metal limiting member 301 abuts against the flexible circuit board 40, impedance of the coplanar waveguide 4001 (as shown in FIG. 20) of the flexible circuit board 40 is pulled down. As a result, the impedance of the coplanar waveguide 4001 suddenly changes, and impedance stability of the coplanar waveguide is reduced.

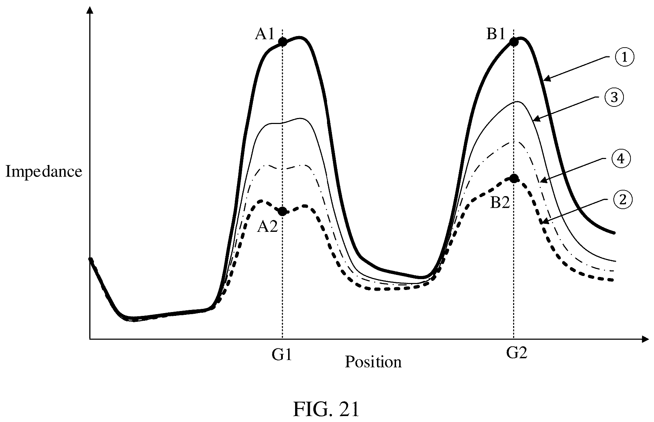

For example, as shown in FIG. 21, a horizontal coordinate represents each position on the flexible circuit board in an extension direction (for example, the X direction in FIG. 20) of the flexible circuit board, and a vertical coordinate represents impedance of the coplanar waveguide. Four curves in the figure respectively represent four different distances between the flexible circuit board and the coplanar waveguide in a case in which the metal limiting member abuts against the flexible circuit board. In all curves, a distance, represented by a curve ①, between the flexible circuit board and the coplanar waveguide is largest. For example, when the flexible circuit board abuts against the first rear housing 31a and the second rear housing 31b in FIG. 4 at a position G1 and a position G2 respectively, impedance of the coplanar waveguide at the position G1 is A1, and impedance of the coplanar waveguide at the position G2 is B 1.

In addition, in all curves, a distance, represented by a curve ④, between the flexible circuit board and the coplanar waveguide is smallest. For example, when the flexible circuit board abuts against the first rear housing 31a and the second rear housing 31b in FIG. 4 at the position G1 and the position G2 respectively, the impedance of the coplanar waveguide at the position G1 is instantly reduced from a point A1 on the curve ① to a point A2 on a curve ②, and the impedance of the coplanar waveguide at the position G2 is instantly reduced from a point B1 on the curve ① to a point B2 on the curve ②.

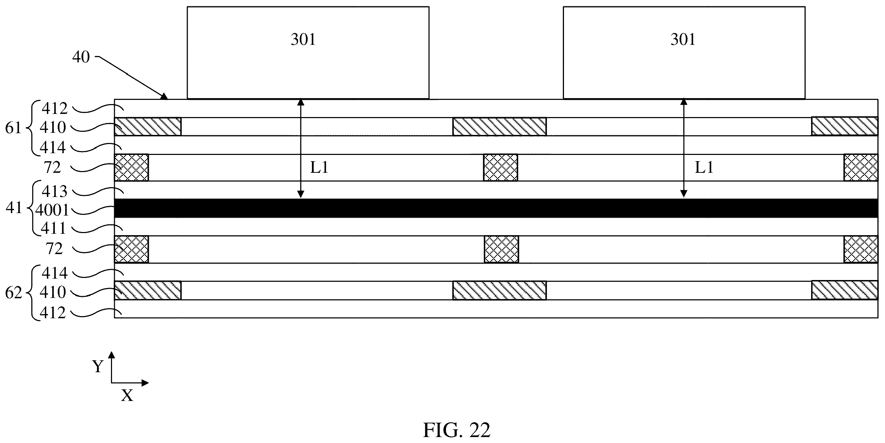

In addition, a curve ③ and the curve ④ represent that distances between the flexible circuit board and the coplanar waveguide in the case in which the metal limiting member abuts against the flexible circuit board are between those represented by the curve ① and the curve ②. Based on this, when no metal layer covers the upper part and the lower part of the coplanar waveguide 4001 (including the transmission line 421 and the ground cable 430 shown in FIG. 17), as shown in FIG. 22, the metal limiting member 301 and the coplanar waveguide 4001 may be isolated from each other via the foregoing insulated dielectric layers, for example, the third dielectric layer 413, the fourth dielectric layer 414, and the second dielectric layer 412. In this way, in the process of bending the electronic device 01, when the flexible circuit board 40 abuts against the metal limiting member 301, the distance between the flexible circuit board and the coplanar waveguide may be increased, so that the impedance of the coplanar waveguide at the position G1 is between the point A1 and the point A2, and the impedance of the coplanar waveguide at the position G2 is between the point B1 and the point B2. This can avoid a large instant change of impedance of the flexible circuit board, to reduce impact of the metal limiting member 301 on impedance stability of the coplanar waveguide in the flexible circuit board 40.

Based on this, to stabilize the impedance of the coplanar waveguide, in some embodiments of this application, still as shown in FIG. 22, when the metal limiting member 301 abuts against the flexible circuit board 40, there is a first distance L1 between the coplanar waveguide 4001 (including the transmission line 421 and the ground cable 430 shown in FIG. 17) and a surface of a side that is of the metal limiting member 301 and that faces the flexible circuit board 40, and $L1 \geq 100 \ \mu m$. In this way, in the process of bending the electronic device 01, when the flexible circuit board 40 abuts against the metal limiting member 301, the distance between the metal limiting member 301 and the coplanar waveguide 4001 may be long enough, so that the impact of the metal limiting member 301 on the impedance stability of the coplanar waveguide in the flexible circuit board 40 can be reduced.

For example, still as shown in FIG. 21, a first distance L1, represented by the curve ③, between the metal limiting member 301 and the coplanar waveguide 4001 in the case in which the flexible circuit board 40 shown in FIG. 22 abuts against the metal limiting member 301 is greater than a first distance L1, represented by the curve ④, between the metal limiting member 301 and the coplanar waveguide 4001 in the case in which the flexible circuit board 40 shown in FIG. 22 abuts against the metal limiting member 301. Therefore, it may be seen that, when the flexible circuit board 40 abuts against the metal limiting member 301, a larger first distance L1 between the metal limiting member 301 and the coplanar waveguide 4001 indicates a smaller impedance reduction amplitude of the coplanar waveguide and stronger impedance stability.

For example, when the flexible circuit board 40 abuts against the metal limiting member 301, and the first distance L1 between the metal limiting member 301 and the coplanar waveguide 4001 meets $L1 \geq 100 \ \mu m$, the electronic device 01 changes from the flattened state to the folded state, an impedance change rate $\Delta Z$ of the coplanar waveguide 4001 may meet the following range: $-10\% \leq \Delta Z \leq +10\%$. In this way, when the flexible circuit board 40 abuts against the metal limiting member 301, the impact of the metal limiting member 301 on the impedance stability of the coplanar waveguide in the flexible circuit board 40 can be reduced.

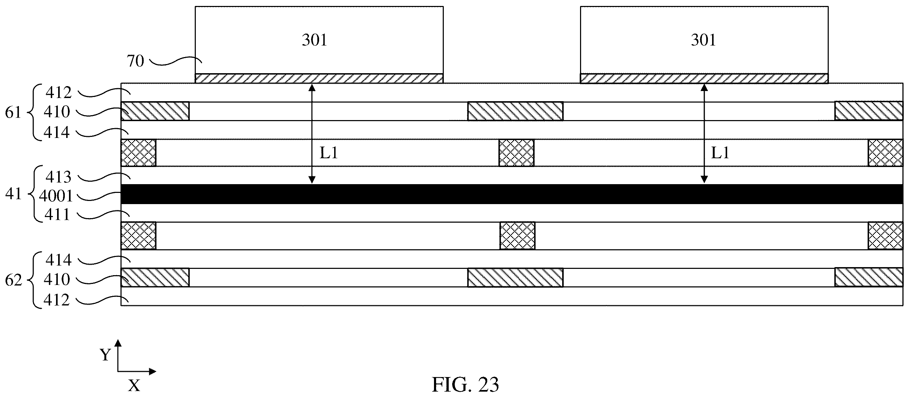

In some other embodiments of this application, to enable the first distance L1 between the metal limiting member 301 and the coplanar waveguide 4001 to meet $L1 \geq 100 \ \mu m$ when the flexible circuit board 40 abuts against the metal limiting member 301, as shown in FIG. 23, the electronic device may further include an insulation layer 70. The insulation layer 70 may be disposed on a side that is of the metal limiting member 301 and that faces the flexible circuit board 40. For example, a layer of non-conductive material, for example, a polymer material like Teflon, may be prepared in a pasting or spraying manner on a surface of the side that is of the metal limiting member 301 and that faces the flexible circuit board 40, so that the impact of the metal limiting member 301 on the impedance stability of the coplanar waveguide in the flexible circuit board 40 is reduced to about 1%.

The foregoing describes the first distance L1 between the metal limiting member 301 and the coplanar waveguide 4001 by using an example in which the metal limiting member 301 is disposed above the flexible circuit board 40. In some other embodiments of this application, the metal limiting member 301 may alternatively be disposed below the flexible circuit board 40. In this case, a method for setting the first distance L1 between the metal limiting member 301 and the coplanar waveguide 4001 is the same as that described above. Details are not described herein again.

In some other embodiments of this application, to improve a deflection characteristic of the entire flexible circuit board 40 on the basis of enabling the first distance L1 between the metal limiting member 301 and the coplanar waveguide 4001 to meet L1 ≥ 100 μm when the flexible circuit board 40 abuts against the metal limiting member 301, the flexible circuit board 40 can be dynamically bent for tens of thousands of times, for example, 50000 times or more, as shown in FIG. 20. An air gap (air gap) 71 may be disposed between the signal layer 41 and either the first reference layer 61 or the second reference layer 62.

In this way, the first distance L1 between the metal limiting member 301 and the coplanar waveguide 4001 may be increased through the air gap 71, so that the first distance L1 meets L1 ≥ 100 μm. In addition, in the process of bending the flexible circuit board 40, the air gap 71 may further provide specific deformation space, to reduce a probability that the deformed signal layer 41 is in contact with either the first reference layer 61 or the second reference layer 62 in the bending region 401, so that the flexible circuit board 40 is more easily bent in the bending region 401, to improve deflection of the flexible circuit board.

Based on this, to form the air gap 71 between the signal layer 41 and either the first reference layer 61 or the second reference layer 62, still as shown in FIG. 20, the flexible circuit board further includes an insulation support part 72. The insulation support part 72 may be located in the air gap 71, and is connected to the signal layer 41 and the reference layer (the first reference layer 61 or the second reference layer 62), so that the insulation support part 72 supports the signal layer 41 and the reference layer adjacent to the signal layer 41, to form the air gap 71. It may be learned from the foregoing description that the flexible circuit board 40 needs to be bent in the bending region 401, and the fastening region 402 of the flexible circuit board 40 does not need to be bent. Therefore, the insulation support part 70 can be disposed in the fastening region 402.

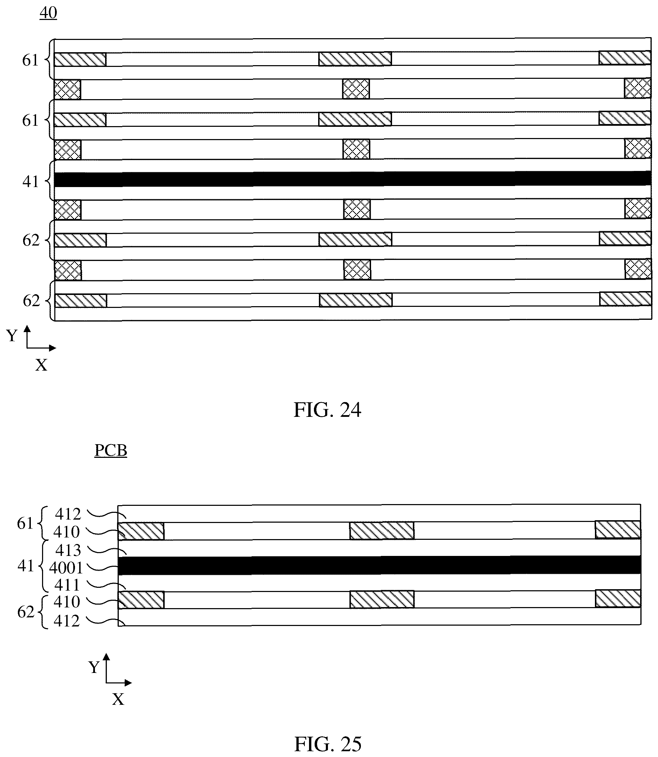

The foregoing description is provided by using an example in which the flexible circuit board 40 includes two reference layers, for example, the first reference layer 61 and the second reference layer 62. In some other embodiments of this application, as shown in FIG. 24, the flexible circuit board 40 may include at least three reference layers, for example, at least two first reference layers 61 disposed above the signal layer 41, and at least two second reference layers 62 disposed below the signal layer 41. In the flexible circuit board 40, there may be the air gap 71 between any two adjacent reference layers, and a disposing manner and technical effect of the air gap 71 are the same as those described above. Details are not described herein again.

Alternatively, in some other embodiments of this application, the flexible circuit board 40 may further include a reference layer stacked with the signal layer 41. The reference layer may be disposed above or below the flexible circuit board 40. The foregoing description is provided by using a quantity of reference layers in the flexible circuit board 40, and does not constitute a limitation on the quantity of reference layers.

The foregoing description is provided by using an example in which the circuit board provided in this embodiment of this application is the flexible circuit board 40. In some other embodiments of this application, the circuit board may alternatively be a PCB. In this case, the PCB may include the signal layer 41. A disposing manner and technical effect of the transmission line 421 and the ground layer 430 in the signal layer 41 are the same as those described above. Details are not described herein again. In addition, the PCB may further include a reference layer stacked with the signal layer 41. A disposing manner of the reference layer is the same as that described above. Details are not described herein again.

Alternatively, in some other embodiments of this application, as shown in FIG. 25, any reference layer in the PGB, for example, either the first reference layer 61 or the second reference layer 62, may have only one dielectric layer, namely, the second dielectric layer 412. In this case, the metal spacer layer 410 in the first reference layer 61 may be located between the third dielectric layer 413 and the second dielectric layer 412, so that the metal spacer layer 410 in the first reference layer 61 and the coplanar waveguide 4001 share the third dielectric layer 413. In addition, the metal spacer layer 410 in the second reference layer 62 may be located between the first dielectric layer 411 and the second dielectric layer 412, so that the metal spacer layer 410 in the second reference layer 62 and the coplanar waveguide 4001 share the first dielectric layer 411. In this way, a quantity of dielectric layers in the PCB can be reduced, and a thickness of the electronic device 01 can be reduced.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A circuit board, comprising a signal layer, wherein the signal layer comprises:

   a first dielectric layer;
   two adjacent signal channels, wherein the signal channel comprises a transmission line, and the transmission line is disposed on the first dielectric layer;
   a first ground part, disposed on the first dielectric layer, wherein the first ground part and the transmission line are located on a surface of a same side of the first dielectric layer; and
   a second ground part, disposed on the first dielectric layer, wherein the second ground part and the transmission line are located on the surface of the same side of the first dielectric layer, the first ground part and the second ground part are located between the two adjacent signal channels, and the first ground part and the second ground part are spaced apart.

2. The circuit board according to claim 1, wherein the circuit board further comprises a reference layer, the reference layer is stacked with the signal layer, and the reference layer comprises:

a second dielectric layer; and
a metal spacer layer, disposed on the second dielectric layer, wherein the metal spacer layer is provided with a second opening that penetrates the metal spacer layer, and the transmission line, the first ground part, and the second ground part are exposed from the second opening.

3. The circuit board according to claim 1 or 2, wherein a first end of the first ground part and a first end of the second ground part are located on a same side and are electrically connected to each other, and a second end of the first ground part and a second end of the second ground part are located on a same side and are electrically connected to each other.

4. The circuit board according to claim 3, wherein the signal layer further comprises:

a first lead, disposed on the first dielectric layer, wherein the first lead is electrically connected to the transmission line, and the metal spacer layer covers the first lead; and
a second lead, disposed on the first dielectric layer, wherein the first ground part and the second ground part that are electrically connected to each other are electrically connected to the same second lead, and the metal spacer layer covers the second lead.

5. The circuit board according to claim 4, wherein a line width of the transmission line is greater than a line width of the first lead.

6. The circuit board according to claim 4, wherein a line width of at least one of the first ground part and the second ground part is greater than a line width of the second lead.

7. The circuit board according to any one of claims 2 to 6, wherein the first dielectric layer and the second dielectric layer are flexible dielectric layers.

8. The circuit board according to claim 7, wherein

the signal layer further comprises a third dielectric layer, the third dielectric layer is stacked with the first dielectric layer, and the transmission line, the first ground part, and the second ground part are located between the first dielectric layer and the third dielectric layer;
the reference layer further comprises a fourth dielectric layer, the fourth dielectric layer is stacked with the second dielectric layer, and the metal spacer layer is located between the second dielectric layer and the fourth dielectric layer; and
the third dielectric layer and the fourth dielectric layer are flexible dielectric layers.

9. The circuit board according to claim 7, wherein there is an air gap between the signal layer and the reference layer.

10. The circuit board according to claim 9, wherein the circuit board further comprises an insulation support part, the insulation support part is located in the air gap, and the insulation support part is connected to the signal layer and the reference layer.

11. The circuit board according to any one of claims 2 to 10, wherein the circuit board comprises at least two stacked reference layers: a first reference layer and a second reference layer; and the signal layer is located between the first reference layer and the second reference layer.

12. The circuit board according to any one of claims 1 to 11, wherein the signal channel comprises two transmission lines.

13. An electronic device, comprising:

a hinge mechanism;
the circuit board according to any one of claims 1 to 12, wherein the circuit board is a flexible circuit board, and a part of the flexible circuit board passes through the hinge mechanism;
a first circuit board, wherein one end of the flexible circuit board is electrically connected to the first circuit board; and
a second circuit board, wherein the first circuit board and the second circuit board are disposed on two sides of the hinge mechanism respectively, and the other end of the flexible circuit board is electrically connected to the second circuit board.

14. The electronic device according to claim 13, wherein the electronic device further comprises:

a metal limiting member, wherein at least a part of the metal limiting member is stacked with the flexible circuit board; the electronic device is in a flattened state, and there is a gap between the metal limiting member and the flexible circuit board; and the electronic device is in a folded state, and the metal limiting member abuts against the flexible circuit board; and

when the metal limiting member abuts against the flexible circuit board, there is a first distance L1 between the transmission line and a surface of a side that is of the metal limiting member and that faces the flexible circuit board, and $L1 \geq 100$ μm.

15. The electronic device according to claim 13 or 14, wherein the electronic device comprises:
an insulation layer, disposed on the side that is of the metal limiting member and that faces the flexible circuit board.

16. The electronic device according to claim 14 or 15, wherein the electronic device comprises:

a middle frame, connected to the hinge mechanism; and
a rear housing, wherein an accommodation cavity is formed between the rear housing and the middle frame, the first circuit board or the second circuit board is located in the accommodation cavity, and a part of the flexible circuit board is located in the accommodation cavity and is electrically connected to the first circuit board or the second circuit board; and
at least one of the middle frame or the rear housing is the metal limiting member.

17. The electronic device according to claim 14 or 15, wherein the electronic device further comprises a display, and the hinge mechanism comprises:

a hinge body, disposed on a back surface of the display; and
a door plate, disposed on the back surface of the display, wherein the door plate is connected to the hinge body and a middle frame, the flexible circuit board is located on a side that is of the door plate and that is away from the display, and the door plate is used as the metal limiting member.

18. The electronic device according to any one of claims 14 to 17, wherein

the first ground part and the second ground part form a coplanar waveguide with a transmission line; wherein the first ground part, the second ground part and the first ground part and transmission line are in a same signal channel; and
for a transition of the electronic device from the flattened state to the folded state, an impedance change rate $\Delta Z$ of the coplanar waveguide falls within the range:

$$- 10\% \leq \Delta Z \leq +10\%.$$

01

FIG. 1

01

FIG. 2

EP 4 734 668 A1

FIG. 3

A1-A2

FIG. 4

19

01

30a

202

30b

402

51

402

401

401

40

402

402

52

Y

X

FIG. 5

B

40

301

FIG. 6

01

FIG. 7

Direction C

FIG. 8A

Direction C

FIG. 8B

D1-D2

FIG. 9

Direction C

41 ——

411

420a

4301

430

421

420b

Y
X

FIG. 10

Direction C

4311 — 421 — 420a — 441

411

41 —

a2

a1

442 —

b2

b1

4301

4312 — 421 — 420b — 441

Y
X

FIG. 11

S1

S2    GND

FIG. 12

Direction C

4311

442

443

400

H1

Y
X

441    4312    421    411

430 { 4311
      4312

FIG. 13A

Direction C

4311

442

443

443

400

4311

H1

Y

X

441    4312    421    411

430 { 4311
      4312

FIG. 13B

EP 4 734 668 A1

Direction C

FIG. 14A

FIG. 14B

FIG. 15

FIG. 16

FIG. 17

Direction E

FIG. 18

Direction E

FIG. 19

EP 4 734 668 A1

EP 4 734 668 A1

F1-F2

FIG. 20

FIG. 21

FIG. 22

EP 4 734 668 A1

FIG. 23

40

61

61

41

62

62

Y
X

FIG. 24

PCB

61 { 412
     410
41 { 413
     4001
     411
62 { 410
     412

Y
X

FIG. 25

## INTERNATIONAL SEARCH REPORT

International application No.

**PCT/CN2024/116551**

### A. CLASSIFICATION OF SUBJECT MATTER

H05K1/02(2006.01)i

According to International Patent Classification (IPC) or to both national classification and IPC

### B. FIELDS SEARCHED

Minimum documentation searched (classification system followed by classification symbols)

IPC:H05K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 电路板, 线路板, 信号, 传输, 线, 接地, 地线, 串扰, 干扰, 柔性, 转轴, 金属, 间隔, 开口, printed circuit board, PCB, PWB, signal, transmission, ground, line, crosstalk, flexible, shaft, metal, spacer, opening

### C. DOCUMENTS CONSIDERED TO BE RELEVANT

| Category* | Citation of document, with indication, where appropriate, of the relevant passages | Relevant to claim No. |
|---|---|---|
| X | CN 114599146 A (GIGALANE CO., LTD.) 07 June 2022 (2022-06-07) description, paragraphs [0005]-[0128], and figures 1-10 | 1, 12 |
| Y | CN 114599146 A (GIGALANE CO., LTD.) 07 June 2022 (2022-06-07) description, paragraphs [0005]-[0128], and figures 1-10 | 13 |
| X | US 2004016569 A1 (MIX, Jason A. et al.) 29 January 2004 (2004-01-29) description, paragraphs [0002]-[0050], and figures 5-8 | 1, 12 |
| Y | CN 113452814 A (HONOR DEVICE CO., LTD.) 28 September 2021 (2021-09-28) description, paragraphs [0002]-[0152], and figures 1-34 | 13 |
| A | CN 116828694 A (CHINA AUTOMOTIVE INNOVATION CORP.) 29 September 2023 (2023-09-29) entire document | 1-18 |
| A | JP 2019220683 A (TOYO INK SC HOLDINGS CO., LTD.) 26 December 2019 (2019-12-26) entire document | 1-18 |

☐ Further documents are listed in the continuation of Box C. ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **28 October 2024** | **15 November 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| | International application No. |
|---|---|
| | **PCT/CN2024/116551** |

| Patent document cited in search report | | | Publication date (day/month/year) | Patent family member(s) | | | Publication date (day/month/year) |
|---|---|---|---|---|---|---|---|
| CN | 114599146 | A | 07 June 2022 | US | 2022183143 | A1 | 09 June 2022 |
| | | | | US | 11844173 | B2 | 12 December 2023 |
| | | | | JP | 2022089148 | A | 15 June 2022 |
| | | | | JP | 7267367 | B2 | 01 May 2023 |
| | | | | KR | 20220078450 | A | 10 June 2022 |
| | | | | KR | 102457122 | B1 | 20 October 2022 |
| US | 2004016569 | A1 | 29 January 2004 | US | 6710266 | B2 | 23 March 2004 |
| CN | 113452814 | A | 28 September 2021 | WO | 2022242221 | A1 | 24 November 2022 |
| CN | 116828694 | A | 29 September 2023 | None | | | |
| JP | 2019220683 | A | 26 December 2019 | None | | | |

Form PCT/ISA/210 (patent family annex) (July 2022)

37

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311636526